# EUROPÄISCHE PATENTANMELDUNG

(11) **EP 2 886 226 A2**
(43) Veröffentlichungstag der Anmeldung: **24.06.2015**
(21) Anmeldenummer: 14194966.9
(22) Anmeldetag: 26.11.2014
(51) Int. Cl.: B22F 3/105

(54) **Belichtung bei generativer Fertigung**

(30) Priorität: 17.12.2013 DE 102013226298
(71) Anmelder: MTU Aero Engines AG, 80995 München (DE)
(72) Erfinder: Göhler, Thomas, 85221 Dachau (DE); Heß, Thomas, 81541 München (DE); Maiwald-Immer, Tobias, 80999 München (DE)

(57) **Zusammenfassung**

Die vorliegende Erfindung betrifft ein Verfahren zur generativen Herstellung von Bauteilen, insbesondere von einkristallinen oder gerichtet erstarrten Bauteilen, insbesondere zur Herstellung von Bauteilen für Strömungsmaschinen, bei welchem das Bauteil schichtweise auf einem Substrat oder einem vorher erzeugten Teil des Bauteils (3) aufgebaut wird, wobei ein schichtweiser Aufbau durch lagenweises Aufschmelzen von Pulvermaterial mit einem energiereichen Strahl (14) und Erstarren der Pulverschmelze (16) erfolgt, wobei der energiereiche Strahl im Bereich des Auftreffens auf das Pulvermaterial einen Strahlquerschnitt (19) aufweist, der gegenüber einem kreisrunden oder sonstigem symmetrischen Querschnitt abgewandelt ist und/oder über dem die Strahlungsenergie ungleichmäßig, insbesondere unsymmetrisch oder exzentrisch verteilt ist, und/oder wobei das Pulvermaterial nach dem Aufschmelzen zeitlich beabstandet zum Aufschmelzen mindestens ein zweites Mal von einem energiereichen Strahl mit gegenüber dem Aufschmelzen verändertem Energieeintrag in das Pulvermaterial bestrahlt wird.

## Beschreibung

### HINTERGUND DER ERFINDUNG

### GEBIET DER ERFINDUNG

Die vorliegende Erfindung betrifft ein Verfahren zur generativen Herstellung von Bauteilen, insbesondere zur Herstellung von Bauteilen für Strömungsmaschinen, bei welchem das Bauteil schichtweise auf einem Substrat oder einem vorher erzeugten Teil des Bauteils aufgebaut wird, wobei ein schichtweiser Aufbau durch lagenweises Aufschmelzen von Pulvermaterial mit einem energiereichen Strahl und Erstarren der Schmelze erfolgt

### STAND DER TECHNIK

Generative Herstellungsverfahren zur Herstellung eines Bauteils, wie beispielsweise stereolithographische Verfahren, selektives Laserschmelzen, selektives Lasersintern, Elektronenstrahlschmelzen oder Laserauftragsschweißen werden in der Industrie für das sogenannte rapid tooling, rapid prototyping oder auch für die Herstellung von Serienprodukten im Rahmen des rapid manufacturing eingesetzt. Insbesondere können derartige Verfahren auch zur Herstellung von Turbinenteilen, insbesondere von Teilen für Flugtriebwerke eingesetzt werden, bei denen beispielsweise auf Grund des verwendeten Materials derartige generative Herstellungsverfahren vorteilhaft sind. Ein Beispiel hierfür findet sich in der DE 10 2010 050 531 A1.

Darüber hinaus ist es bei Bauteilen für Strömungsmaschinen aufgrund der Einsatzbedingungen und der erforderlichen Eigenschaften vorteilhaft, einkristalline oder gerichtet erstarrte Bauteile einzusetzen, um die Anisotropie von Eigenschaften, wie beispielsweise unterschiedliche mechanischen Eigenschaften bezüglich der Kristallorientierung gezielt auszunutzen. So ist es beispielsweise bekannt, Turbinenschaufeln aus einkristallinen oder gerichtet erstarten Nickel - Basis - Superlegierungen herzustellen. Einkristallin bedeutet hierbei, dass das Bauteil aus einem einzigen Kristall gebildet ist, so dass keine Korngrenzen vorliegen. Bei gerichtet erstarrten Bauteilen liegen in dem Bauteil zwar mehrere Kristallkörner vor, diese sind jedoch bezüglich ihrer Kristallorientierung nahezu gleich und insbesondere in einer bevorzugten Richtung orientiert, um die besonderen Eigenschaften entlang der Vorzugsrichtung auszunutzen.

Da die Herstellung von derartigen Bauteilen sehr aufwändig ist, ist bereits versucht worden, derartige Bauteile auch durch generative Verfahren herzustellen, was beispielsweise bei Kleinserien vorteilhaft sein kann. Beispiele hierfür sind in der EP 0 861 927 A1, der EP 0 892 090 A1, WO 2004/028786 A1, WO 2013/029959 A1 oder der DE 10 2009 051 479 A1 beschrieben.

Allerdings besteht weiterhin Bedarf zur Verbesserung der bekannten Verfahren, um die Qualität der erzeugten einkristallinen oder gerichtet erstarrten Bauteile zu verbessern und die Verfahren reproduzierbar in einem industriellen Maßstab einsetzen zu können. Insbesondere bedarf es eines Verfahrens, mit dem die gezielte Steuerung des lagenweisen Aufbaus möglich ist, um Anisotropieeigenschaften des hergestellten Bauteils definiert einstellen zu können.

### OFFENBARUNG DER ERFINDUNG

### AUFGABE DER ERFINDUNG

Es ist deshalb Aufgabe der vorliegenden Erfindung, ein generatives Verfahren zur Herstellung insbesondere einkristalliner oder gerichtet erstarrter Bauteile bereit zu stellen, welches reproduzierbare und verlässliche Ergebnisse hoher Qualität hinsichtlich der gezielten Erstarrung, insbesondere der Einkristalleigenschaften einkristallin erstarrter Bauteile oder der gleichmäßigen Orientierung der Kristallite in gerichtet erstarrten Bauteilen liefert. Gleichzeitig soll das Verfahren einfach und effektiv anwendbar sein.

### TECHNISCHE LÖSUNG

Diese Aufgabe wird gelöst durch ein Verfahren mit den Merkmalen des Anspruchs 1. Vorteilhafte Ausgestaltungen sind Gegenstand der abhängigen Ansprüche.

Die vorliegende Erfindung geht aus von der Erkenntnis, dass eine Verbesserung im Sinne der oben genannten Aufgabenstellung dadurch erreicht werden kann, dass bei einem generativen Herstellungsverfahren mit lagenweisem Aufschmelzen von Pulvermaterial mit einem energiereichen Strahl und Erstarren der Pulverschmelze der energiereiche Strahl so gewählt wird, dass er einen gegenüber einem kreisrunden Querschnitt abgewandelten Querschnitt im Bereich des Auftreffens auf das Pulvermaterial aufweist. Alternativ oder zusätzlich kann die Strahlungsenergie ungleichmäßig, insbesondere unsymmetrisch oder exzentrisch über dem Strahlquerschnitt des energiereichen Strahls im Bereich des Auftreffens auf das Pulvermaterial verteilt sein. Nach einer weiteren Gestaltung, die wiederum alternativ oder zusätzlich verwirklicht werden kann, kann das Pulvermaterial nach dem Aufschmelzen zeitlich beabstandet zum Aufschmelzen mindestens ein zweites Mal von einem energiereichen Strahl bestrahlt werden, der einen gegenüber dem Aufschmelzen veränderten Energieeintrag in das Pulvermaterial bewirkt. Mit all diesen Maßnahmen kann in einfacher, aber gleichzeitig eine gezielte Erstarrung des aufgeschmolzenen Pulvermaterials ermöglicht werden. Insbesondere kann ein epitaktisches Aufwachsen des lagenweise abgeschiedenen Materials ermöglicht, um so einkristalline oder gerichtet erstarrte Bauteile herzustellen. Allerdings können die Verfahrensparameter auch so gewählt werden, dass eine globulitische Erstarrung erzielt wird. Je nach Anwendungsfall lassen sich die Verfahrensparameter so einstellen, dass die gewünschte Erstarrungstruktur erzielt wird.

Die zeitlich beabstandete, zwei- oder mehrfache Bestrahlung desselben Pulvermaterials mit unterschiedlichen Bestrahlungsenergien kann durch Bestrahlung des Pulvermaterials bzw. des Bauteils mit zwei oder mehreren energiereichen Strahlen, die unabhängig voneinander erzeugt werden können, verwirklicht werden.

Die Bestrahlung mit einem zweiten oder weiteren energiereichen Strahlen kann hierbei zu Zeiten erfolgen, an denen das bei der ersten Bestrahlung aufgeschmolzene Pulvermaterial noch nicht erstarrt ist, insbesondere noch nicht vollständig erstarrt ist.

Ähnlich wie bei der Energiezufuhr zu dem aufgeschmolzenen Pulvermaterial mit mehreren energiereichen Strahlen nach dem Aufschmelzen kann auch das Aufschmelzen des Pulvermaterials mit mehreren energiereichen Strahlen bewirkt werden, die insbesondere zeitlich nacheinander auf das Pulvermaterial einwirken. Drüber hinaus ist auch eine Vorwärmung des Pulvermaterials mit energiereichen Strahlen, aber auch mit anderen Heizeinrichtungen möglich.

Die energiereichen Strahlen können Laser- oder Elektronenstrahlen sein.

Bei der vorgeschlagenen Erfindung kann die generative Herstellung des Bauteils durch lagenweises Aufschmelzen von Pulvermaterial dadurch bewirkt werden, dass der oder die energiereichen Strahlen entlang von Bewegungsbahnen über das in einem Pulverbett angeordnete Pulvermaterial geführt werden.

Die Bewegungsbahnen, entlang der die energiereichen Strahlen geführt werden, können einander insbesondere überlappen, um ein mehrmaliges Bestrahlen des gleichen Pulvermaterials bzw. des bereits aufgeschmolzenen und/oder wieder erstarrten Pulvermaterials auch mit einem einzigen energiereichen Strahl zu bewirken. Allerdings können die Bewegungsbahnen auch so gewählt werden, dass die Bewegungsbahnen entsprechend dem jeweiligen Strahlquerschnitt im Bereich des Auftreffens auf das Pulvermaterial einander nicht überlappen.

Ferner kann der Bahnabstand in geeigneter Weise gewählt werden, um die gewünschte Temperaturverteilung im Pulvermaterial bzw. der Schmelze und dem bereits erstarrten Bauteil einzustellen.

Insgesamt kann eine computergestützte Simulation des Energieeintrags und der örtlichen und/oder zeitlichen Temperaturverteilung im Pulvermaterial und/oder dem bereits hergestellten Bauteil und/oder der Schmelze erzeugt werden, um mittels der computergestützten Simulation die Verfahrensparameter so einstellen zu können, dass die gewünschte Erstarrungsstruktur, wie beispielsweise eine globulitische Struktur oder insbesondere einkristalline oder gerichtet Erstarrung des Bauteils erzielt wird.Mit dem vorgestellten Verfahren besteht somit die Möglichkeit der gezielten Steuerung der Erstarrung der abgeschiedenen Materiallagen und somit die gezielte Ausnutzung von Anisotropieeffekten des Materials durch definierte Erstarrung.

Hierzu kann durch die computergestützte Simulation der Phasenzustand des Pulvermaterial und/oder die Erstarrungsrichtung und/oder die Erstarrungsgeschwindigkeit des aufgeschmolzenen Pulvermaterials bestimmt werden, sodass durch Variation ein oder mehrerer Parameter der Bestrahlung mit dem energiereichen Strahl die gewünschte Abscheidung eingestellt werden kann. So können die Parameter der energiereichen Strahlen hinsichtlich der Leistung des oder der energiereichen Strahlen, die Anzahl der energiereichen Strahlen, die Form des Strahlquerschnitts des oder der energiereichen Strahlen, die ungleichmäßige, insbesondere unsymmetrische oder exzentrische Energieverteilung über dem Strahlquerschnitt des oder der energiereichen Strahlen, der zeitliche Abstand einer zweiten oder weiteren Bestrahlung des Pulvermaterials, die Geometrie der Bahnen der energiereichen Strahlen und der Bahnabstand der Bewegungsbahnen der energiereichen Strahlen eingestellt bzw. variiert werden.

Insbesondere kann so ein epitaktisches Aufwachsen des Materials bei der lagenweisen Abscheidung realisiert werden. Außerdem ist es möglich verschiedene Orientierungen der erstarrten Kristallite einzustellen, so dass beispielsweise in verschiedenen abgeschiedenen Lagen unterschiedliche Kristallorientierungen eingestellt werden können. So ist es möglich in jeder abgeschiedenen Lage oder nach mehreren gleichen Lagen eine andere Kristallorientierung einzustellen. Auf diese Weise können Anisotropieeffekte auch in globulitisch erstarrten Gefügen genutzt werden, wenn in den einzelnen Lagen oder mehreren Lagen zwar jeweils getrennte und unterschiedlich orientierte Kristallite vorliegen, aber diese definiert orientiert sind.

Entsprechend kann mit der computergestützten Simulation die Auswahl der Parameter für die Bestrahlung so erfolgen, dass die Erstarrungsbedingungen so sind, dass einkristalline oder gerichtet erstarrte Bauteile erzeugt werden können.

### KURZBESCHREIBUNG DER FIGUREN

Die beigefügten Zeichnungen zeigen in rein schematischer Weise in
- Fig.1: eine schematische Darstellung einer Vorrichtung zur generativen Herstellung von Bauteilen am Beispiel des selektiven Laserschmelzens;
- Fig.2: eine teilweise Schnittansicht durch ein bereits erzeugtes Bau- teil und das Pulverbett mit dem aufgeschmolzenen und erstarren- den Bereich; und in
- Fig.3: eine Darstellung der Bewegungsbahnen und des Strahlquerschnitts von Laserstrahlen bei der Durchführung des erfindungsgemäßen Verfahrens.

### AUSFÜHRUNGSBEISPIELE

Weitere Vorteile, Kennzeichen und Merkmale der vorliegenden Erfindung werden bei der nachfolgenden detaillierten Beschreibung eines Ausführungsbeispiels deutlich, wobei die Erfindung nicht auf dieses Ausführungsbeispiel beschränkt ist.

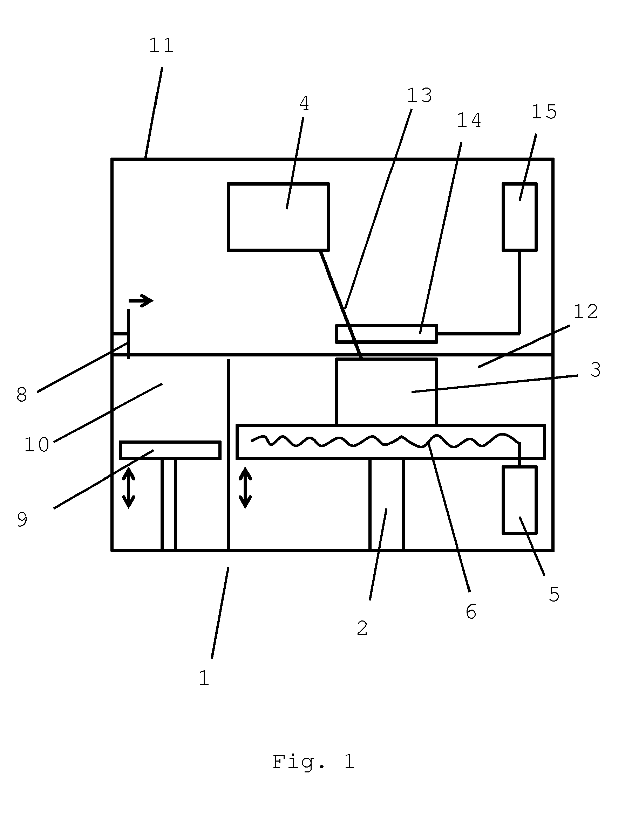

Die Figur 1 zeigt in einer rein schematischen Darstellung eine Vorrichtung 1, wie sie beispielsweise für das selektive Laserschmelzen zur generativen Herstellung eines Bauteils Verwendung finden kann. Die Vorrichtung 1 umfasst einen Hubtisch 2, auf dessen Plattform ein Halbzeug 3 angeordnet ist, auf dem schichtweise Material abgeschieden wird, um ein dreidimensionales Bauteil zu erzeugen. Hierzu wird mittels des Schiebers 8 Pulver 10, das sich oberhalb eines Hubtisches 9 in einem Pulvervorrat befindet, schichtweise über das Halbzeug 3 geschoben und anschließend durch den Laserstrahl 13 eines Lasers 4 durch Aufschmelzen mit dem bereits vorhandenen Halbzeug 3 verbunden. Die Verbindung des Pulvermaterials in einer Pulverschicht mit dem Halbzeug 3 erfolgt durch den Laser 4 abhängig von der gewünschten Kontur des zu fertigenden Bauteils, sodass beliebige, dreidimensionale Formen erzeugt werden können. Entsprechend wird der Laserstrahl 13 über das Pulverbett 12 geführt, um durch unterschiedliche Auftreffpunkte auf dem Pulverbett entsprechend der Kontur des dreidimensionalen Bauteils in der der erzeugten Schichtebene entsprechenden Schnittebene Pulvermaterial aufzuschmelzen und mit dem bereits erzeugten Teil eines Bauteils oder einem anfänglich bereit gestellten Substrat zu verbinden. Hierbei kann der Laserstrahl 13 durch eine geeignete Ablenkeinheit über die Oberfläche des Pulverbetts 12 geführt werden und/oder das Pulverbett könnte gegenüber dem Laserstrahl 13 bewegt werden.

Um unerwünschte Reaktionen mit der Umgebungsatmosphäre beim Aufschmelzen oder Sintern zu vermeiden, kann der Prozess in einem abgeschlossenen Raum, der durch ein Gehäuse 11 der Vorrichtung 1 bereit gestellt wird, stattfinden und es kann zudem eine inerte Gasatmosphäre bereit gestellt, um beispielsweise Oxidation des Pulvermaterials und dergleichen beim Abscheiden zu vermeiden. Als inertes Gas kann beispielsweise Stickstoff verwendet werden, welches über eine nicht dargestellte Gasversorgung bereit gestellt wird.

Anstelle des Inertgases könnte auch ein anderes Prozessgas verwendet werden, wenn beispielsweise eine reaktive Abscheidung des Pulvermaterials gewünscht ist.

Darüber hinaus sind auch andere Strahlungsarten denkbar, wie beispielsweise Elektronenstrahlen oder andere Teilchenstrahlen oder Lichtstrahlen, die bei der Stereolithographie eingesetzt werden.

Zur Einstellung der gewünschten Temperaturen im erzeugten Bauteil 3 und/oder im Pulverbett 12 ist im Hubtisch eine elektrische Widerstandsheizung mit einer Widerstandsheizungssteuerung 5 und einem elektrischen Heizdraht 6 vorgesehen, so dass das Pulverbett 12 und das Bauteil 3 durch entsprechendes Erwärmen von unten auf eine gewünschte Temperatur gebracht werden können und/oder ein gewünschter Temperaturgradient, insbesondere zu der gerade bearbeiteten Schicht an der Oberfläche des Pulverbetts, eingestellt werden kann. In ähnlicher Weise ist eine Beheizung mit einer Heizungseinrichtung von der Oberseite des Pulverbetts 12 und des bereits erstellten Bauteils 3 vorgesehen, die bei dem gezeigten Ausführungsbeispiel durch eine Induktionsheizung mit einer Induktionsspule 14 und einer Induktionsheizungssteuerung 15 gebildet ist. Die Induktionsspule 14 umgibt hierbei den Laserstrahl 13 und ist bei Bedarf parallel zur Oberfläche des Pulverbetts 12 entsprechend dem Laserstrahl 13 bewegbar.

Anstelle der dargestellten Induktionsheizung kann auch jede andere Heizungsart, die eine Erwärmung des Pulverbetts 12 und des bereits erzeugten Bauteils 3 von der Oberseite ermöglicht, vorgesehen werden, wie beispielsweise Strahlungsheizgeräte, wie Infrarotstrahler und dergleichen. In gleicher Weise kann auch die Widerstandsheizung 5, 6 durch geeignete andere Heizungsarten, die eine Erwärmung des Pulverbetts 12 und des bereits erzeugten Bauteils 3 von unten ermöglichen, ersetzt werden. Darüber hinaus können weitere Heizeinrichtungen umgebend um das bereits erzeugte Bauteil 3 und/oder das Pulverbett 12 vorgesehen werden, um eine seitliche Erwärmung des Pulverbetts 12 und/oder des bereits erzeugten Bauteils 3 zu ermöglichen.

Neben Heizeinrichtungen können auch Kühleinrichtungen oder kombinierte Heiz-/Kühleinrichtungen vorgesehen werden, um neben einer Erwärmung des bereits erzeugten Bauteils 3 und des Pulverbetts 12 auch eine gezielte Abkühlung vornehmen zu können, um dadurch den Temperaturhaushalt im Pulverbett 12 und/oder dem erzeugten Bauteil 3, insbesondere in Bezug auf die durch den Laserstrahl 13 aufgeschmolzene Pulverschicht und die Erstarrungsfront an dem aufgeschmolzenem Pulvermaterial gezielt einstellen und beeinflussen zu können.

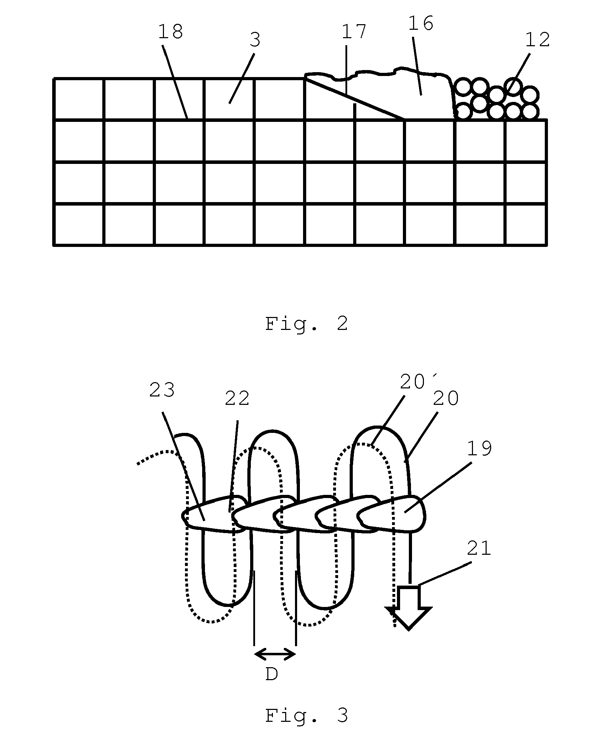

Die Fig. 2 zeigt die Situation im Bereich einer gerade auf dem bereits erzeugten Bauteil 3 aufzubringenden weiteren Lage im Bereich der Erstarrungsfront.

In der Fig. 2 ist ein Teil des bereits erzeugten Bauteils 3 zu sehen, sowie ein Teil des Pulverbetts 12 mit den Pulverpartikeln vor dem Aufschmelzen. Neben den Pulverpartikeln des Pulverbetts 12 befindet sich die Schmelze 16 des bereits aufgeschmolzenen Pulvermaterials, nachdem der Laserstrahl 14 auf das Pulvermaterial des Pulverbetts 12 aufgetroffen ist. Da der Laserstrahl 14, welcher zur Erzeugung der Kontur in der entsprechenden Lage des Bauteils über das Pulverbett 12 weitergeführt wird, kühlt sich die Schmelze 16 nach dem Bestrahlen durch den Laserstrahl 14 wieder ab, so dass es zur Erstarrung des aufgeschmolzenen Pulvermaterials kommt. Hierbei bildet sich abhängig von der Temperaturverteilung in der Schmelze 16 und den umgebenden Bereichen eine Erstarrungsfront 17 aus, die in Richtung der Schmelze 16 und in Richtung des eingestellten und ausgerichteten Temperaturgradienten fortschreitet und an der sich das geschmolzene Material in erstarrte Material umwandelt.

Erfindungsgemäß wird die Energieeinbringung durch den oder die Laserstrahlen 14 und die Heizeimichtungen 5, 6, 14, 15 so geführt, dass die gewünschte Erstarrungsstruktur und Kristallorientierung erreicht wird. Durch eine langsame Erstarrungsgeschwindigkeit, d. h. langsames Fortschreiten der Erstarrungsfront 17 bei gleichzeitig hohem Temperaturgradienten an der Erstarrungsfront kann eine planare einkristalline Erstarrung des aufgeschmolzenen Pulvermaterials bzw. ein epitaktisches Aufwachsen desselben an dem bereits erzeugten Bauteil 3 erfolgen. Dies ist in der Fig. 2 schematisch durch die Darstellung eines einheitlichen Gitters 18 verdeutlicht, welches die einheitliche Kristallstruktur des bereits erzeugten Bauteils 3 und der erstarrenden Schmelze 16 an der Erstarrungsfront 17 darstellt.

Die Fig. 3 zeigt in einer schematischen Darstellung die Bewegung eines oder mehrerer Laserstrahlen 14 über das Pulverbett 12. Wie in Fig. 3 dargestellt, bewegt sich der Laserstrahl beispielsweise in Form einer mäanderförmigen Bewegungsbahn 20 über das im Pulverbett 12 vorliegende Pulvermaterial. Bei der Bewegungsbahn 20 bewegt sich der Laserstrahl 14 in Richtung des Pfeiles 21 entlang der Bewegungsbahn 20.

Der Strahlquerschnitt 19 im Bereich der Auftrefffläche des Laserstrahls auf das Pulvermaterial ist in den gezeigten Ausführungsbeispielen nicht kreisrund, sondern in einer abgerundeten Keilform ausgebildet. Zugleich ist die Strahlungsenergieverteilung ungleichmäßig über dem Strahlquerschnitt, und zwar so, dass im Bereich des dickeren Endes des keilförmigen Strahlquerschnitts eine höhere Strahlungsenergie pro Fläche vorliegt als im spitzen Ende des keilförmigen Strahlquerschnitts. Dies bedeutet, dass der Strahlquerschnitt 19 einen im Durchmesser größeren Aufschmelzbereich 22 und einen im Durchmesser kleineren Nachwärmbereich 23 aufweist. Damit ist die Strahlungsenergie ungleichmäßig über den Strahlquerschnitt 19 verteilt ist, und zwar so, dass im Aufschmelzbereich 22 eine höhere Strahlungsenergie vorhanden ist, als im Nachwärmbereich 23.

Die Bewegungsbahn 20 des Laserstrahls 14 ist nun so gestaltet, dass bei der mäanderförmigen Bahn die parallelen Bahnabschnitte durch einen Abstand D getrennt sind, der kleiner ist als die Längsstreckung des Strahlquerschnitts 19, so dass der Strahlquerschnitt 19 mit dem bereits bestrahlten Bereich zumindest teilweise überlappt. Insbesondere wird der Laserstrahl 14 entlang der Bewegungsbahn 20 so geführt, dass der Nachwärmbereich 23 des Strahlquerschnitts 19 bei der weiteren Bewegung des Laserstrahls 14 in dem Bereich überlappt, in dem vorher das Pulvermaterial durch den Aufschmelzbereich 22 des Strahlquerschnitts 19 aufgeschmolzen worden ist. Dadurch kann mit einem einzigen Laserstrahl 14 das Aufschmelzen und die erforderliche Nachwärmung zur Erzielung einer niedrigen Erstarrungsgeschwindigkeit und/oder eines hohen Temperaturgradienten in einfacher Weise erzeugt werden.

Alternativ oder zusätzlich ist es möglich, einen zweiten Laserstrahl zeitlich nachfolgend auf der gleichen Bewegungsbahn 20 und/oder gleichzeitig und/oder zeitlich versetzt auf einer zweiten, zur ersten Bewegungsbahn 20 örtlich versetzten Bewegungsbahn 20'zu führen, um zusammen mit den Heizeimichtungen 5, 6, 14, 15 die gewünschte Temperaturverteilung im Bereich des Pulverbetts 12, der Schmelze 16, der Erstarrungsfront 17 und dem bereits erzeugten Bauteil 3 einzustellen, so dass ein epitaktisches Aufwachsen des erstarrenden Pulvermaterials auf dem bereits erzeugten Bauteil 3 oder einem bereitgestellten Substrat erfolgt.

Durch die beschriebenen Maßnahmen lassen sich die Temperaturverhältnisse in der Schmelze und Umgebung und somit die Höhe und Richtung des Temperaturgradienten an der Erstarrungsfront sowie deren Geschwindigkeit und Richtung beim Verlauf durch die Schmelze steuern und somit die Erstarrungsrichtung und die Orientierung des oder der erstarrten Kristallite einstellen.

Anstelle eines vollständig epitaktischen Aufwachsens zur Erzielung eines einkristallinen Bauteils kann abhängig von den gewählten Verfahrensparametern auch ein gerichtet erstarrtes Aufwachsen zur Schaffung eines Bauteils mit mehreren Kristallkörnern, die entlang einer bevorzugten Richtung ausgerichtet sind, verwirklicht werden. Außerdem lassen sich globulitisch erstarrte Gefüge erzeugen.

Obwohl die vorliegende Erfindung anhand der Ausführungsbeispiele detailliert beschrieben worden ist, ist für den Fachmann selbstverständlich, dass die Erfindung nicht auf diese Ausführungsbeispiele beschränkt ist, sondern dass vielmehr Änderungen in der Weise möglich sind, dass einzelne Merkmale weggelassen oder andersartige Kombinationen von Merkmalen verwirklicht werden können, solange der Schutzbereich der beigefügten Ansprüche nicht verlassen wird. Die vorliegende Offenbarung schließt sämtliche Kombinationen der vorgestellten Einzelmerkmale mit ein.

## Patentansprüche

1. Verfahren zur generativen Herstellung von Bauteilen, insbesondere zur Herstellung von Bauteilen für Strömungsmaschinen, bei welchem das Bauteil schichtweise auf einem Substrat oder einem vorher erzeugten Teil des Bauteils (3) aufgebaut wird, wobei ein schichtweiser Aufbau durch lagenweises Aufschmelzen von Pulvermaterial mit einem energiereichen Strahl (14) und Erstarren der Pulverschmelze (16) erfolgt,
**dadurch gekennzeichnet, dass**
der energiereiche Strahl im Bereich des Auftreffens auf das Pulvermaterial einen Strahlquerschnitt (19) aufweist, der gegenüber einem kreisrunden oder sonstigem symmetrischen Querschnitt abgewandelt ist und/oder über dem die Strahlungsenergie ungleichmäßig, insbesondere unsymmetrisch oder exzentrisch verteilt ist, und/oder dass
das Pulvermaterial nach dem Aufschmelzen zeitlich beabstandet zum Aufschmelzen mindestens ein zweites Mal von einem energiereichen Strahl mit gegenüber dem Aufschmelzen verändertem Energieeintrag in das Pulvermaterial bestrahlt wird.

2. Verfahren nach Anspruch 1,
**dadurch gekennzeichnet, dass**
mindestens zwei energiereiche Strahlen (14) zeitlich nacheinander an örtlich benachbarten Stellen des Bauteils oder eines Teils davon auf das Pulvermaterial einstrahlen.

3. Verfahren nach Anspruch 1 oder 2,
**dadurch gekennzeichnet, dass**
die zweite oder weitere Bestrahlungen mit einem energiereichen Strahl (14) zu Zeitpunkten erfolgen, an welchen das aufgeschmolzene Pulvermaterial noch nicht erstarrt, zumindest noch nicht vollständig erstarrt ist.

4. Verfahren nach einem der vorhergehenden Ansprüche,
**dadurch gekennzeichnet, dass**
vor dem Aufschmelzen eine Vorwärmung des Pulvermaterials erfolgt, insbesondere durch Strahlungsheizung oder induktiver Heizung.

5. Verfahren nach einem der vorhergehenden Ansprüche,
**dadurch gekennzeichnet, dass**
der energiereiche Strahl (14) ein Laser - oder Elektronenstrahl ist.

6. Verfahren nach einem der vorhergehenden Ansprüche,
**dadurch gekennzeichnet, dass**
der oder die energiereichen Strahlen entlang von Bewegungsbahnen (20,20') über das in einem Pulverbett angeordnete Pulvermaterial geführt werden.

7. Verfahren nach Anspruch 6,
**dadurch gekennzeichnet, dass**
die Bewegungsbahnen (20,20') der energiereichen Strahlen, insbesondere der energiereichen Strahlen mit vom kreisrunden oder sonstigem symmetrischen Strahlquerschnitt abweichendem Strahlquerschnitt (19) und/oder ungleichmäßiger und/oder unsymmetrischer und/oder exzentrischer Energieverteilung über dem Strahlquerschnitt, und/oder die Bewegungsbahnen, bei denen der energiereiche Strahl das Pulvermaterial zumindest teilweise zum Aufschmelzen des Pulvermaterials zum ersten Mal trifft, einander überlappen.

8. Verfahren nach einem der vorhergehenden Ansprüche,
**dadurch gekennzeichnet, dass**
eine computergestützte Simulation des Energieeintrags und der örtlichen und/oder zeitlichen Temperaturverteilung in dem Pulvermaterial und/oder dem bereits hergestellten Bauteil (3) erfolgt.

9. Verfahren nach einem der vorhergehenden Ansprüche,
**dadurch gekennzeichnet, dass**
eine computergestützte Simulation des Phasenzustands des Pulvermaterials und/oder der Erstarrungsrichtung und/oder der Erstarrungsgeschwindigkeit des aufgeschmolzenen Pulvermaterials erfolgt.

10. Verfahren nach Anspruch 8 oder 9,
**dadurch gekennzeichnet, dass**
mit Hilfe der computergestützten Simulation ein oder mehrere Parameter für die Bestrahlung mit energiereichen Strahlen bestimmt werden, wobei die Parameter ausgewählt werden aus der Gruppe, die die Leistung des oder der energiereichen Strahlen, die Anzahl der energiereichen Strahlen, die Form des Strahlquerschnitts des oder der energiereichen Strahlen, die ungleichmäßige oder unsymmetrische oder exzentrische Energieverteilung über dem Strahlquerschnitt des oder der energiereichen Strahlen, den zeitlichen Abstand einer zweiten oder weiteren Bestrahlung des Pulvermaterials, die Geometrie der Bahnen der energiereichen Strahlen und den Bahnabstand der Bewegungsbahnen der energiereichen Strahlen umfasst.

11. Verfahren nach Anspruch 10,
**dadurch gekennzeichnet, dass**
mit Hilfe der computergestützten Simulation die Parameter für die Bestrahlung mit energiereichen Strahlen so bestimmt werden, dass eine gewünschte Gefügeausbildung realisiert wird.

12. Verfahren nach einem der vorhergehenden Ansprüche,
**dadurch gekennzeichnet, dass**
das Erstarren der Schmelze epitaktisch erfolgt. Verfahren nach einem der vorhergehenden Ansprüche,
**dadurch gekennzeichnet, dass**
das Verfahren zur Herstellung einkristalliner oder gerichtet erstarrter Bauteile verwendet wird.
